# EUROPEAN PATENT SPECIFICATION

(11) **EP 0 859 540 B1**
(45) Date of publication and mention of the grant of the patent: **02.11.2000**
(21) Application number: 97303593.4
(22) Date of filing: 27.05.1997
(51) Int. Cl.: H05K 3/12, H05K 3/34

(54) **Method and apparatus for screen printing and soldering an electronic component onto a printed circuit board**
Verfahren und Vorrichtung zum Siebdrucken und Löten von elektronischen Bauelementen auf eine gedruckte Leiterplatte
Procédé et appareil de sérigraphie et de soudage de composants électroniques sur une plaquette de circuit imprimé

(30) Priority: 06.02.1997 JP 3838197; 06.02.1997 JP 3838297
(43) Date of publication of application: 19.08.1998
(73) Proprietor: TDK Corporation, Chuo-ku, Tokyo (JP)
(72) Inventor: Yagi, Hiroshi, Ichikawa-shi, Chiba (JP); Ohira, Hiroyuki, Matsudo-shi, Chiba (JP)
(74) Representative: Geering, Keith Edwin

(56) References cited:
- EP-A- 0 469 848
- DE-A- 4 139 357
- GB-A- 2 132 538
- US-A- 4 552 300
- US-A- 5 526 978

## Description

This invention relates to a screen printing method and an apparatus therefor, and a method for soldering an electronic component onto a board using screen printing and an apparatus therefor, and more particularly to a screen printing method adapted to screen-print creamed solder or paste solder for soldering an electronic component onto a board and an apparatus therefor, as well as a method for applying paste solder to a board by screen printing to carry out soldering of an electronic component onto the board and an apparatus therefor.

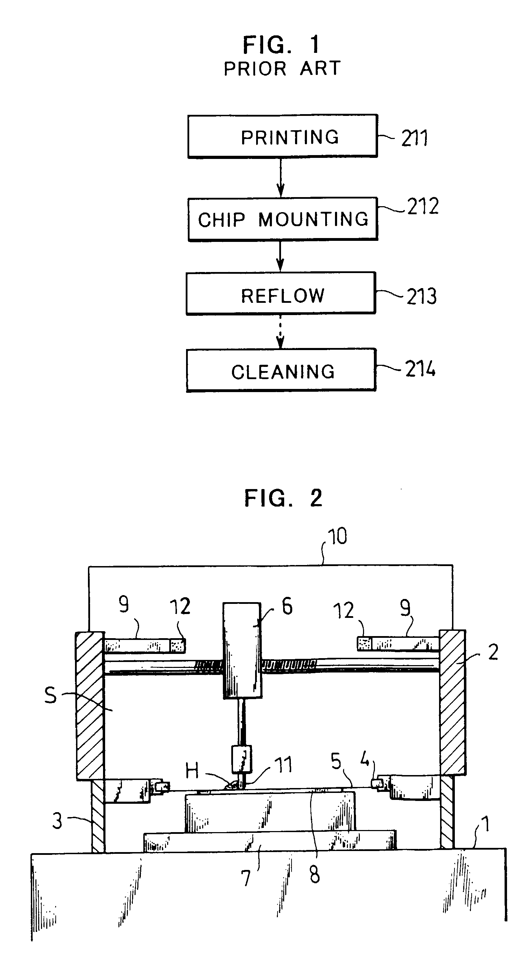

Conventionally, soldering of an electronic component (hereinafter also referred to as "chip") onto a board is carried out as shown in Fig. 1. More specifically, first a printing step 211 is executed to print paste solder onto a board by a screen printing apparatus and then a chip mounting step 212 is carried out to mount a chip or chips on the board by means of a chip mounting apparatus, followed by execution of a reflow step 213 wherein the paste solder is melted in a reflow oven to fix the chip or chips on the board.

Such soldering is conventionally practiced in an open air atmosphere. Unfortunately, this fails to prevent generation of solder balls dissociated from a land on the board during the soldering in the reflow oven. In particular, reflow soldering under increased moisture conditions causes generation of a number of solder balls dissociated from the land of the board, leading to a failure in the board.

Also, a flux ingredient contained in the paste solder is desirably reduced as much as possible when elimination of a cleaning step after soldering of a chip or chips onto the board is desired. Unfortunately, in the case of reflow soldering in the open air atmosphere which is conventionally carried out, a reduction in flux content in the paste solder fails to permit the paste solder to exhibit satisfactory soldering characteristics.

Thus, in the prior art, the reflow step 213 is followed by a cleaning step 214 as shown in Fig. 1.

Also, it is conventionally proposed to carry out reflow soldering in a closed nitrogen atmosphere for the purpose of preventing oxidation of paste solder. Unfortunately, this requires to construct a soldering system into a closed structure, leading to an increase in cost of the system and deterioration in efficiency of soldering by the system.

In view of the foregoing disadvantages of the conventional reflow soldering, we proposed a reflow oven for carrying out reflow soldering in a dry air atmosphere, as disclosed in US-A-5,526.978. The proposed reflow oven exhibits advantages of minimizing generation of solder balls, eliminating the necessity of constructing a soldering system into a closed structure and attaining screen printing and reflow soldering on a large scale.

We have now found that screen printing of printing paste on a board is advantageously conducted in a dry air atmosphere. When the printing paste is paste solder, and an electronic component is mounted on the screen printed board followed by reflow soldering, said mounting is also preferably conducted in a dry air atmosphere. In the art, screen printing of paste on a board and mounting of a chip or chips on the board are currently carried out in an open air atmosphere; we have found that this allows absorption of moisture in a flux ingredient of the paste solder on screen printing or condensation or dewing of moisture on the applied paste solder during the chip mounting, so that generation of solder balls may be increased irrespective of execution of reflow soldering in a dry air atmosphere. The invention uses a dry air atmosphere for one or both of the screen printing and the chip mounting.

We have found that when a reflow oven is employed for reflow soldering in a dry air atmosphere, both screen printing of paste solder by screen printing apparatus and chip mounting by chip mounting apparatus are desirably carried out in a dry air atmosphere. The prior art fails to suggest such operation.

The present invention can provide a screen printing method and apparatus capable of effectively preventing printed paste such as paste solder from absorbing moisture when screen printing of the paste is executed.

The present invention can provide method and apparatus for soldering an electronic component which are capable of effectively preventing generation of solder balls during reflow soldering in a dry air atmosphere, to thereby eliminate cleaning of a board after soldering.

In accordance with one aspect of the present invention, a screen printing method is provided. The screen printing method includes the step of carrying out screen printing of a printing paste on a board in a dry air atmosphere. The printing paste may be paste solder and the dry air atmosphere may have a humidity of 20% or less.

In accordance with another aspect of the present invention, a screen printing apparatus is provided. The screen printing apparatus includes a printing screen, a squeegee movable on the printing screen and an enclosure in which a treating space having a board, the printing screen and the squeegee for application of a printing paste arranged therein is defined, wherein the treating space is formed therein with a dry air atmosphere of a pressure slightly higher than that of an atmosphere outside the treating space.

In accordance with a further aspect of the present invention, a method for soldering an electronic component is provided. The method includes the steps of executing screen printing of paste solder on a board, mounting an electronic component on the board to which the paste solder is applied and subjecting the board mounted thereon with the electronic component to reflow soldering, wherein the screen printing is executed in a dry air atmosphere. The dry air atmosphere may have a humidity of 20% or less. Also, at least one of the mounting of the electronic component and the reflow soldering may be carried out in a dry air atmosphere.

In accordance with still another aspect of the present invention, an apparatus for soldering an electronic component is provided. The apparatus includes a screen printing unit for applying paste solder arranged on a printing screen to a board by printing while superposing the printing screen on the board, a mounting unit for mounting, by means of a mounting head, an electronic component on the board to which the paste solder is applied by printing, and a reflow oven including an oven body provided therein with a heater and constructed so as to melt the paste solder on the board mounted thereon with the electronic component, to thereby carry out reflow soldering. The screen printing unit includes an enclosure in which a treating space having the board, the printing screen and a squeegee arranged therein is defined. The treating space is formed therein with a dry air atmosphere of a pressure slightly higher than that of an atmosphere outside the treating space.

In a preferred embodiment of the present invention, the mounting unit may include an enclosure in which a treating space having the board and mounting head arranged therein is defined. The treating space of the chip mounting unit is formed therein with a dry air atmosphere of a pressure slightly higher than that of an atmosphere outside the treating space of the chip mounting unit.

In a preferred embodiment of the present invention, the oven body of the reflow oven is fed therein with dry air to form a dry air atmosphere in the oven body.

### BRIEF DESCRIPTION OF THE DRAWINGS

These and other objects and many of the attendant advantages of the present invention will be readily appreciated as the same becomes better understood by reference to the following detailed description when considered in connection with the accompanying drawings; wherein:
Fig. 1 is a block diagram showing steps of a conventional method for soldering of an electronic component;
Fig. 2 is a schematic front elevation view in section showing a screen printing apparatus which may be incorporated in the present invention;
Fig. 3 is a perspective view of the screen printing apparatus shown in Fig. 2;
Fig. 4 is a block diagram showing a dry unit adapted to be used in the present invention;
Fig. 5 is a block diagram showing steps of soldering of an electronic component according to the present invention;
Fig. 6 is a schematic front elevation view in section showing a mounting apparatus for mounting the electronic component which may be incorporated in the present invention; and
Fig. 7 is a schematic front elevation view in section showing a reflow oven which may be incorporated in the present invention.

### DETAILED DESCRIPTION OF THE PREFERRED EMBODIMENTS

Now, the present invention will be described hereinafter with reference to the accompanying drawings.

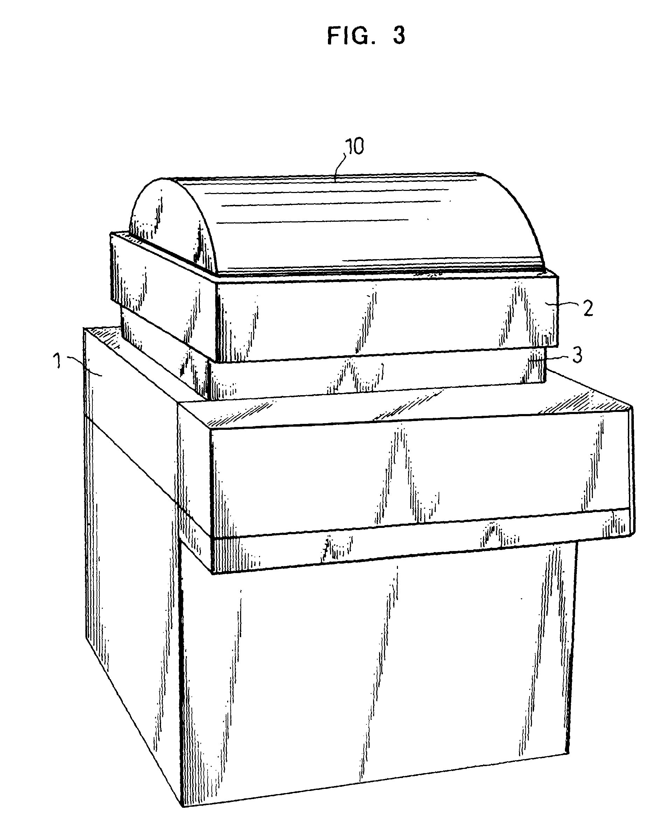

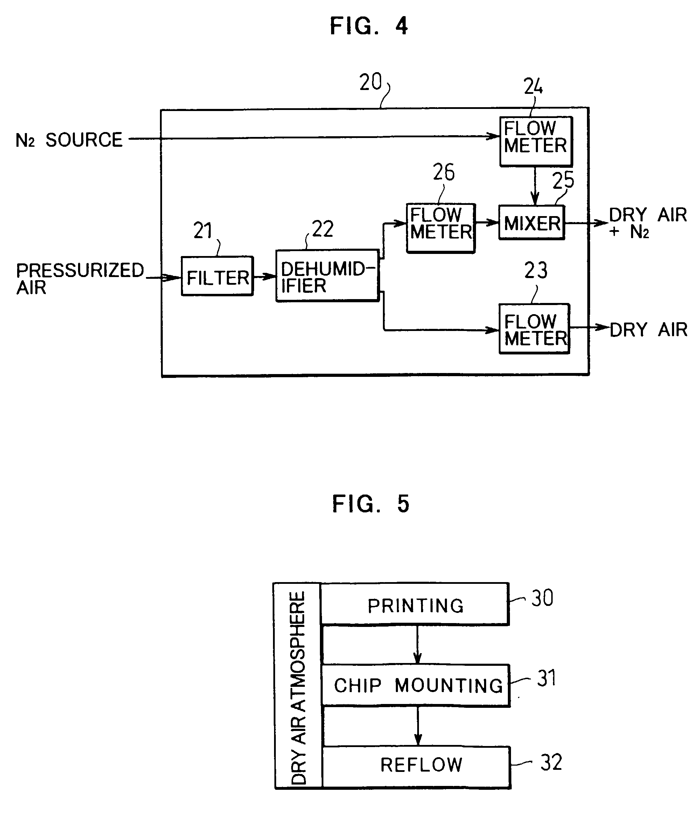

First, a screen printing method and an apparatus therefor according to the present invention will be described with reference to Figs. 2 to 4, wherein Figs. 2 and 3 show an embodiment of a screen printing apparatus according to the present invention and Fig. 4 shows a dry unit for feeding dry air to the screen printing apparatus.

As shown in Figs. 2 and 3, the screen apparatus includes a base 1, a frame 2 for supporting a squeegee head 6, a frame 3 for supporting a printing screen frame 4, a printing screen 5, an X-Y table 7 on which a board 8 is placed, a dry air feed section 9, and a plastic cover 10 for airtightly closing an upper opening of the printing apparatus.

The frame 2 for supporting the squeegee head 6 and the frame 3 for supporting the printing screen frame 4 are securely mounted on the base 1. The printing screen frame 4 is held on the frame 3 through a lifting means provided on the frame 3. This results in the printing screen frame 4 being downwardly moved to a lowered position, to thereby lay or superpose the printing screen 5 on the board 8 when the printing is desired and upwardly moved to a raised position when replacement of the board 8 and/or printing screen 5 is desired. The squeegee head 6 is supported on the frame 2, for example, through an X-direction drive mechanism and provided on a lower end thereof with a squeegee 11. The squeegee head 6 is constructed so as to be reciprocated in the frame 2, resulting in the board 8 being coated thereon with paste solder H on the screen 5 by means of the squeegee 11 mounted on the lower end of the squeegee head 6.

The base 1, frames 2 and 3, and plastic cover 10 cooperate with each other to form an essential part of an enclosure which is provided therein with a treating space S for printing having the board 8, the printing screen 5 and the squeegee 11 for application of the paste solder or printing paste H arranged therein while being formed therein with a dry air atmosphere of a pressure slightly higher than that of an atmosphere outside the treating space S. Thus, the treating space S which has the board 8, printing screen 5 and squeegee 11 arranged therein is defined in the enclosure while being formed therein with a dry air atmosphere of a pressure slightly higher than that of an atmosphere outside the treating space S. Also, the screen printing apparatus is provided with an elastic porous member for closing any gap which may possibly exist on a side surface of the apparatus. For example, a sponge material may be used for this purpose. Thus, the treating space S is in the form of a substantially sealed space which is surrounded by the base 1, frames 2 and 3, and plastic cover 10. It is not necessarily required to construct the treating space S in a fully airtight manner so long as it permits a dry air atmosphere of a pressure slightly higher than that of an atmosphere outside the treating space S to be formed therein. For this purpose, the screen printing apparatus may be so constructed that a whole area of an opening of the dry air feed section 9 is larger than a whole area of the gap.

The dry air feed section 9 is formed with an air outlet, which is provided thereon with a porous member 12 made of sintered metal or the like, resulting in dry air being fed through the porous member 12 to the treating space S for printing defined by the base 1, frames 2 and 3 and plastic cover 10 substantially without a flow velocity or while being kept substantially free from a flow velocity. The air outlet or opening of the dry air feed section 9 is desirably arranged at a position which keeps a dry air stream from being brought into a direct contact with the board 8. For example, it may be arranged at a height corresponding to an upper portion of the squeegee head 6. Dry air to be fed desirably has a humidity of 20% or less.

The dry unit designated at reference numeral 20 in Fig. 4 is constructed so as to guide pressurized air from a compressor to a filter 21 to remove dust from the air, followed by introduction of the air into a dehumidifier 22 to remove moisture from the air, resulting in dry air being provided. Preferably, a humidity of the air is reduced to a level of 20% or less. Then, the thus-obtained dry air is fed through a flow meter 23 to the dry air feed section 9.

Nitrogen may be fed through a flow meter 24 to a mixer 25 as desired, wherein the nitrogen is mixed with dry air fed through the dehumidifier 22 and a flow meter 26 to prepare mixed gas, which is then fed to the dry air feed section 9.

The above-described construction of the screen printing apparatus of the illustrated embodiment permits the treating space S for printing to be formed therein with a dry air atmosphere which is substantially free from a flow velocity and of which a pressure is kept at a level slightly higher than that outside the space S. The squeegee 11 is reciprocated in the thus-formed treating space S, resulting in screen printing of the paste solder H being carried out. This effectively prevents a deterioration in paste solder H due to moisture during the screen printing. Thus, a flux ingredient contained in the paste solder H is prevented from absorbing moisture, resulting in generation of solder balls during reflow soldering subsequent thereto being prevented. This eliminates a necessity of cleaning the board after it is mounted thereon with electronic components and the like.

The humidity of the dry air of 20% or less further enhances prevention of generation of the solder balls.

In the illustrated embodiment, the paste solder H is printed as a printing paste. It is a matter of course that the present invention may be effectively applied to any other printing paste that is easily affected by moisture.

As can be seen from the foregoing, the illustrated embodiment permits screen printing to be executed in a dry air atmosphere, to thereby prevent absorption of moisture by a printing paste such as paste solder and condensation of moisture on the printing paste, resulting in fabrication and assembling of a board being accomplished with increased reliability. Also, application of the illustrated embodiment to screen printing of paste solder permits subsequent reflow soldering to be executed in a dry air atmosphere, to thereby prevent generation of solder balls, so that cleaning of the board which was subsequently carried out in the prior art may be eliminated.

Referring now to Fig. 5, soldering of an electronic component or chip soldering which is an embodiment according to the present invention is generally illustrated. The chip soldering generally includes a printing step 30 of printing paste solder on a board by means of a screen printing apparatus which may be constructed as described above with reference to Fig. 2, a chip mounting step 31 of mounting the chip on the board by means of a chip mounting apparatus and a reflow step of melting the paste solder in a reflow oven to solder the chip on the board.

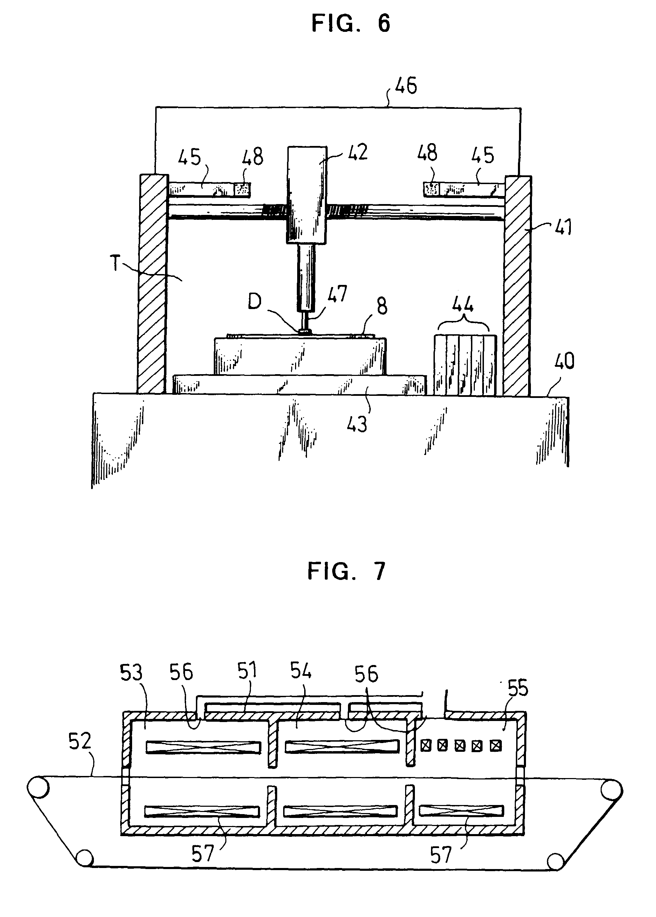

The chip mounting apparatus for the chip mounting step 31 may be constructed in such a manner as shown in Fig. 6, which is adapted to mount, in a dry air atmosphere, a chip on a board coated thereon with paste solder by printing. In Fig. 6, reference numeral 40 designates a base for the chip mounting apparatus, 41 is a frame for supporting a chip mounting head 42, 43 is an X-Y table on which a board 8 is placed, 44 is a chip feed section, 45 is a dry air feed section, and 46 is a plastic cover for closing an upper opening of the chip mounting apparatus.

The chip mounting head supporting frame 41 is securely mounted on the base 40 so as to upwardly extend therefrom, and the chip mounting head 42 is provided on a lower end thereof with a suction nozzle 47 and arranged so as to be reciprocated in the frame 41. Thus, the chip mounting head 42 is moved in the frame 41 so as to permit the suction nozzle 47 to pick up a chip D from the chip feed section 44 and place it on the board 8 coated with the paste solder.

In the chip mounting apparatus thus constructed, the base 40, frame 41, plastic cover 46 cooperate with each other to form an essential part of an enclosure which is provided therein with a treating space T for chip mounting having the board 8 and chip mounting head 42 arranged therein while being formed therein with a dry air atmosphere of a pressure slightly higher than that of an atmosphere outside the treating space T for chip mounting. Thus, the treating space T which has the board 8 and mounting head 42 arranged therein is defined in the enclosure while being formed therein with a dry air atmosphere of a pressure slightly higher than that of an atmosphere outside the treating space T. Also, the chip mounting apparatus is provided with an elastic porous member for closing any gap which may possibly exist on a side surface of the apparatus. For example, a sponge material may be used for this purpose. Thus, the treating space T for chip mounting is in the form of a substantially sealed space which is surrounded by the base 40, frame 41 and plastic cover 46. It is not necessarily required to construct the treating space T for chip mounting into a fully airtight structure so long as it permits a dry air atmosphere of a pressure slightly higher than that of an atmosphere outside the treating space T to be formed therein. For this purpose, the chip mounting apparatus may be so constructed that a whole area of an opening of the dry air feed section 45 is larger than a whole area of the gap.

The dry air feed section 45 is formed with an air outlet, which is provided thereon with a porous member 48 made of sintered metal or the like, resulting in dry air being fed through the porous member 48 to the treating space T for chip mounting defined by the base 40, frame 41 and plastic cover 46 substantially without a flow velocity or while being kept from being substantially provided with a flow velocity. The air outlet or opening of the dry air feed section 45 is desirably arranged at a position which keeps a dry air stream from being brought into a direct contact with the board 8. For example, it may be arranged at a height corresponding to an upper portion of the chip mounting head 42. Dry air to be fed desirably has a humidity of 20% or less.

The reflow oven briefly described above which is used for the reflow soldering step 32 in the chip soldering of the illustrated embodiment may be constructed in such a manner as shown in Fig. 7. In Fig. 7, reference numeral 51 designates an oven body of the non-closed type and 52 is a conveyor. The oven body 51 is partitioned into preheating sections 53 and 54 and a reflow section 55, each of which has a heater 57 arranged therein. The preheating sections 53 and 54 and reflow section 55 may each be fed with dry air through a dry air feed passage 56.

Thus, boards, each of which has been mounted thereon with a chip or chips by the chip mounting apparatus as described above, are transferred into the oven body 51 in order by means of the conveyor 52, resulting in the board being subjected to reflow soldering in a dry air atmosphere. Dry air to be fed to the oven body 51 desirably has a humidity of 20% or less. Feeding of the dry air may be carried out by means of the dry unit 20 described above with reference to Fig. 4.

Now, the manner of chip soldering or chip mounting by soldering of the illustrated embodiment will be described hereinafter.

First, the printing step 30 shown in Fig. 5 is executed by means of the screen printing apparatus shown in Fig. 2, wherein the printing screen 5 is superposed on the board 8 placed on the X-Y table 7 and paste solder H on the printing screen 5 is printed or coated on the board 8 by means of the squeegee 11. Coating of the paste solder H by printing is carried out in a dry air atmosphere formed in the treating space S for printing in which the board 8, screen 5 and squeegee 11 are arranged and kept at a pressure slightly higher than that outside the space S. The dry air atmosphere is kept from being substantially provided with a flow velocity and has a humidity of 20% or less. Thus, the screen printing is effectively accomplished while preventing in a deterioration in paste solder H due to moisture or preventing moisture from being absorbed in a flux ingredient of the paste solder H.

The board 8 which has been thus coated thereon with the paste solder H is then subjected to the chip mounting step 31 (Fig. 5) by means of the chip mounting apparatus shown in Fig. 6. More particularly, the board 8 is transferred to the X-Y table 43 of the chip mounting apparatus shown in Fig. 6 and then the suction nozzle 47 arranged on the lower end of the chip mounting head 42 is moved to pick up a chip D from the chip feed section 44 and mount it on the board 8 through the paste solder. The chip mounting may be likewise executed in a dry air atmosphere formed in the treating space T for chip mounting in which the board 8 and mounting head 42 are arranged and which is kept at a pressure slightly higher than that outside the space T. The dry air atmosphere is kept substantially free from a flow velocity and has a humidity of 20% or less. Thus, the chip mounting is accomplished without causing a deterioration in paste solder H due to moisture or while preventing moisture from being absorbed in the flux ingredient of the paste solder H.

Then, the board 8 is subjected to the reflow soldering step 32 (Fig. 5) in the reflow oven shown in Fig. 7. More particularly, the board which has been subjected to the chip mounting by the chip mounting apparatus is transferred to the conveyor 52 of the reflow oven shown in Fig. 7 and transported into the oven body 51 with traveling of the conveyor 52. In the oven body 51, the paste solder deposited on the board 8 is melted, resulting in reflow soldering of the chip to the board being executed. The reflow soldering may be likewise carried out in a dry air atmosphere having a humidity of 20% or less.

Thus, the chip soldering of the illustrated embodiment exhibits satisfactory advantages. More specifically, the screen printing apparatus includes the enclosure in which the treating space S for printing having the board 8, printing screen 5 and squeegee 11 arranged therein is defined, wherein the treating space S is formed therein with a dry air atmosphere of a pressure slightly higher than that of an atmosphere outside the treating space S. Such construction prevents the paste solder from being deteriorated due to absorption of moisture in the flux ingredient of the solder during coating of the paste solder on the board 8 by printing. Also, it prevents condensation of moisture on the paste solder.

The chip mounting unit includes the enclosure in which the treating space T for chip mounting having the board 8 and chip mounting head 42 arranged therein is defined, wherein the treating space T is formed therein with a dry air atmosphere of a pressure slightly higher than that of an atmosphere outside the treating space T. Such construction likewise prevents the paste solder from being deteriorated due to absorption of moisture in the flux ingredient of the solder during the chip mounting. Also, it prevents condensation of moisture on the paste solder and chip.

The reflow oven is fed with dry air to carry out the reflow soldering in a dry air atmosphere in the oven body 51. Also, the screen printing and chip mounting prior to the flow soldering are executed in a dry air atmosphere. Such construction substantially fully prevents a deterioration in paste solder due to moisture throughout the whole processing. Also, it ensures satisfactory soldering while reducing a content of flux in the paste solder, to thereby prevent generation of solder balls and eliminate cleaning of the board after soldering the chip to the board.

Further, the illustrated embodiment permits the dry air fed to each of the screen printing apparatus, chip mounting apparatus and reflow oven to have a humidity as low as 20% or less. This further contributes to prevention of generation of solder balls.

In the illustrated embodiment, transfer of the board 8 to the screen printing apparatus, chip mounting apparatus and reflow oven desirably takes place in a dry air atmosphere. Also, the screen printing apparatus, chip mounting apparatus and reflow oven may be mutually connected in order through passages kept at a dry air atmosphere, for example, of 20% or less in humidity, to thereby provide a continuous line.

The screen printing apparatus and chip mounting apparatus may be constructed in any desired manner so long as the screen printing apparatus includes the enclosure in which the treating space for printing having the board, printing screen and squeegee arranged therein is defined, wherein the treating space is formed therein with a dry air atmosphere which has a pressure slightly higher than that of an atmosphere outside the treating space and is kept substantially free from a flow velocity and likewise the chip mounting apparatus includes the enclosure in which the treating space for chip mounting having the board and chip mounting head arranged therein is defined, wherein the treating space is formed therein with a dry air atmosphere which has a pressure slightly higher than that of an atmosphere outside the treating space and is kept substantially free from a flow velocity.

As can be seen from the foregoing, the present invention permits screen printing of paste solder on a board and mounting of a chip or chips on the board to be executed in a dry air atmosphere, to thereby prevent absorption of moisture by the flux ingredient of the paste solder. This prevents generation of solder balls, so that the soldering may be accomplished with increased reliability. Also, it minimizes generation of solder balls while reducing a content of flux content in the paste solder, to thereby eliminate a necessity of cleaning the board after the soldering.

While preferred embodiments of the invention have been described with a certain degree of particularity with reference to the drawings, obvious modifications and variations are possible in light of the above teachings. It is therefore to be understood that within the scope of the appended claims, the invention may be practiced otherwise than as specifically described.

## Claims

1. A screen printing method comprising screen printing printing paste (H) on a board (8) in a dry air atmosphere.

2. A method according to claim 1 wherein said printing paste is paste solder.

3. A method of mounting an electronic component (D) on a board (8) comprising screen printing a paste solder (H) on the board (8) in a dry atmosphere, mounting the electronic component (D) on the board (8) to which the paste solder (H) is applied, and subjecting the board (8) with the electronic component (D) mounted thereon to reflow soldering, one or both of said mounting of the electronic component and said reflow soldering optionally being carried out in a dry air atmosphere.

4. A method according to claim 3 wherein said mounting of the electronic component is executed in a substantially closed treating space (T) while keeping a dry air atmosphere in said treating space (T) at a higher pressure than that of an atmosphere outside said treating space (T).

5. A method according to any preceding claim, wherein said screen printing is executed in a substantially closed treating space (S) while keeping said dry air atmosphere at a pressure slightly higher than that of an atmosphere outside said treating space (S).

6. A method according to any preceding claim wherein said dry atmosphere or at least one of said dry atmospheres has a humidity of 20% or less.

7. A screen printing apparatus comprising a printing screen (5) and a squeegee (11) movable on said printing screen (5), characterised in that :
the apparatus further comprises an enclosure in which a treating space (S) having a board (8), said printing screen (5) and said squeegee (11) for application of a printing paste (H) arranged therein is defined;
said treating space (S) being formed therein with a dry air atmosphere of a pressure slightly higher than that of an atmosphere outside said treating space.

8. An apparatus for soldering an electronic component comprising:
a screen printing unit for applying paste solder (H) arranged on a printing screen (5) to a board (8) by printing while superposing said printing screen (5) on the board (8);
a mounting unit for mounting, by means of a mounting head (42), an electronic component (D) on the board (8) to which the paste solder (H) is applied by printing; and
a reflow oven including an oven body (51) provided therein with heater (57) and constructed so as to melt the paste solder (H) on the board (8) mounted thereon with the electronic component (D), to thereby carry out reflow soldering, characterised in that:
said screen printing unit includes an enclosure in which a treating space (S) having the board (8), said printing screen (5) and a squeegee (11) arranged therein is defined; and
said treating space (S) is formed therein with a dry air atmosphere of a pressure slightly higher than that of an atmosphere outside said treating space (S).

9. An apparatus according to claim 8 wherein said electronic component mounting unit includes a second enclosure in which a second treating space (T) having the board (8) and said mounting head (42) arranged therein is defined; and
said second treating space (T) is formed therein with a dry air atmosphere of a pressure slightly higher than that of an atmosphere outside said second treating space (T).

10. An apparatus according to claim 8 or 9 wherein said oven body (51) of said reflow oven is fed therein with dry air to form a dry air atmosphere in said oven body (51).

## Patentansprüche

1. Ein Siebdruckverfahren mit einer Siebdruckpaste (H) auf einer Platte (8) in einer Heißluftatmosphäre.

2. Verfahren nach Anspruch 1, wobei die Druckpaste eine Lötpaste darstellt.

3. Verfahren zum Montieren einer elektronischen Komponente (D) auf einer Platte (8), mit
Siebdrucken einer Lötpaste (H) auf der Platte (8) in einer Heißluftatmosphäre, Montieren der elektronischen Komponente (D) auf der Platte (8), auf der die Lötpaste (H) aufgetragen wurde, und
Durchführen einer Aufschmelzlötung mit der Platte (8) und der darauf montierten elektronischen Komponente (D), wobei das Montieren der elektronischen Komponente und/oder das Aufschmelzlöten in einer Heißluftatmosphäre durchgeführt werden.

4. Verfahren nach Anspruch 3, wobei das Montieren der elektronischen Komponente in einem im wesentlichen geschlossenen Behandlungsraum (T) durchgeführt wird, während der Druck einer Heißluftatmosphäre in dem Behandlungsraum (T) derart aufrechterhalten wird, dass er höher als der Druck außerhalb des Behandlungsraumes (T) ist.

5. Verfahren nach einem der vorherigen Ansprüche, wobei das Siebdrucken in einem im wesentlichen geschlossenen Behandlungsraum (S) durchgeführt wird, während der Druck der Heißluftatmosphäre derart aufrechterhalten wird, dass er ein wenig höher als der Druck außerhalb des Behandlungsraumes (S) ist.

6. Verfahren nach einem der vorherigen Ansprüche, wobei die Heißluftatmosphäre oder zumindest eine der Heißluftatmosphären eine Feuchtigkeit von 20 % oder weniger aufweist.

7. Siebdruckvorrichtung mit einem Drucksieb (5) und einem auf dem Drucksieb (5) beweglichen Abstreifer (11),
dadurch gekennzeichnet, dass die Vorrichtung ferner ein Gehäuse aufweist, in dem ein eine Platte (8), das Drucksieb (5) und den Abstreifer (11) zum Auftragen einer Druckpaste (H) enthaltender Behandlungsraum (S) definiert ist, und eine Heißluftatmosphäre in dem Behandlungsraum (S) ausgebildet ist, deren Druck ein wenig höher als der Druck außerhalb des Behandlungsraumes ist.

8. Vorrichtung zum Löten einer elektronischen Komponente mit
einer Siebdruckeinheit zum Auftragen einer auf einem Drucksieb (5) angeordneten Lötpaste (H) auf eine Platte (8) mittels Drucken, während das Drucksieb (5) auf die Platte (8) aufgelegt wird,
eine Montiereinheit zum Montieren einer elektronischen Komponente (D) mittels eines Montierkopfes (42) auf der Platte (8), auf der die Lötpaste (H) durch Drucken aufgetragen wird, und
einem Aufschmelzofen, der einen Ofenkörper (51) mit einer Heizeinrichtung (57) enthält, und die Lötpaste (H) auf der mit einer elektronischen Komponente (D) bestückten Platte (8) schmilzt, um dadurch ein Aufschmelzlöten durchzuführen,
dadurch gekennzeichnet, dass
die Siebdruckeinheit ein Gehäuse aufweist, in dem ein die Platte (8), das Drucksieb (5) und einen Abstreifer (11) enthaltender Behandlungsraum (S) definiert ist, und
eine Heißluftatmosphäre in dem Behandlungsraum (S) ausgebildet ist, deren Druck höher als der Druck der Atmosphäre außerhalb des Behandlungsraumes (S) ist.

9. Vorrichtung nach Anspruch 8, wobei die Einheit zum Montieren elektronischer Komponenten ein zweites Gehäuse einschließt, in dem ein zweiter die Platte (8) und den Montierkopf (42) enthaltender Behandlungsraum (T) definiert ist, und
eine Heißluftatmosphäre in dem zweiten Behandlungsraum (T) ausgebildet ist, deren Druck ein wenig höher als der Druck der Atmosphäre außerhalb des zweiten Behandlungsraumes (T) ist.

10. Vorrichtung nach Anspruch 8 oder 9, wobei der Ofenkörper (51) des Aufschmelzofens mit Heißluft gefüllt wird, um eine Heißluftatmosphäre in dem Ofenkörper (51) auszubilden.

## Revendications

1. Procédé d'impression par sérigraphie comprenant l'impression par sérigraphie d'une pâte (H) d'impression sur un panneau (8) en atmosphère d'air sec.

2. Procédé selon la revendication 1, dans lequel la pâte d'impression est une soudure en pâte.

3. Procédé de montage d'un composant électronique (D) sur une carte (8), comprenant l'impression par sérigraphie d'une soudure en pâte (H) sur la carte (8) en atmosphère sèche, le montage du composant électronique (D) sur la carte (8) à laquelle la soudure en pâte (H) est appliquée, et l'application d'un soudage par refusion à la carte (8) sur laquelle est monté le composant électronique (D), l'une au moins des opérations de montage de composant électronique et de soudage par refusion étant exécutée éventuellement en atmosphère d'air sec.

4. Procédé selon la revendication 3, dans lequel le montage de composant électronique est réalisé dans un espace de traitement (T) pratiquement fermé avec conservation d'une atmosphère d'air sec dans l'espace de traitement (T) à une pression supérieure à celle d'une atmosphère à l'extérieur de l'espace de traitement (T).

5. Procédé selon l'une quelconque des revendications précédentes, dans lequel l'impression par sérigraphie est réalisée dans un espace pratiquement fermé (S) de traitement avec maintien de l'atmosphère d'air sec à une pression légèrement supérieure à celle de l'atmosphère en dehors de l'espace de traitement (S).

6. Procédé selon l'une quelconque des revendications précédentes, dans lequel l'atmosphère sèche et/ou l'une des atmosphères sèches a un degré d'humidité inférieur ou égal à 20 %.

7. Appareil d'impression par sérigraphie, comprenant un écran d'impression (5) et une raclette (11) mobile sur l'écran d'impression (5), caractérisé en ce que :
l'appareil comporte en outre une enceinte dans laquelle est délimité un espace de traitement (S) dans lequel sont placés une carte (8), l'écran d'impression (5) et la raclette (11) d'application d'une pâte d'impression (H),
l'espace de traitement (S) étant formé avec une atmosphère d'air sec à une pression légèrement supérieure à celle de l'atmosphère en dehors de l'espace de traitement.

8. Appareil de soudage avec apport d'un composant électronique, comprenant :
une unité d'impression par sérigraphie destinée à appliquer de la soudure en pâte (H) disposée sur un écran d'impression (5) à une carte (8) par impression avec superposition de l'écran d'impression (5) à la carte (8),
une unité de montage, à l'aide d'une tête de montage (42), d'un composant électronique (D) sur la carte (8) à laquelle la soudure en pâte (H) est appliquée par l'impression, et
un four de refusion comprenant un corps (51) de four muni d'un organe de chauffage (57) et construit afin qu'il fasse fondre la soudure en pâte (H) sur la carte (8) sur laquelle est monté le composant électronique (D), afin que le soudage par refusion soit exécuté, caractérisé en ce que :
l'unité d'impression par sérigraphie comprend une enceinte dans laquelle est délimité un espace de traitement (S) dans lequel sont placés la carte (8), l'écran d'impression (5) et une raclette (11), et
l'espace de traitement (S) est formé avec une atmosphère d'air sec à une pression légèrement supérieure à celle de l'atmosphère à l'extérieur de l'espace de traitement (s).

9. Appareil selon la revendication 8, dans lequel l'unité de montage de composant électronique comprend une seconde enceinte dans laquelle est délimité un second espace de traitement (T) dans lequel sont placés la carte (8) et la tête de montage (42), et
le second espace de traitement (T) est réalisé avec une atmosphère d'air à une pression légèrement supérieure à celle de l'atmosphère à l'extérieur du second espace de traitement (T).

10. Appareil selon la revendication 8 ou 9, dans lequel le corps (51) du four de refusion reçoit de l'air sec destiné à former une atmosphère d'air sec dans le corps du four (51).
